(19) Europäisches Patentamt
European Patent Office
Office européen des brevets

(11) **EP 4 651 381 A1**

(12) **EUROPEAN PATENT APPLICATION**

(43) Date of publication:
**19.11.2025 Bulletin 2025/47**

(21) Application number: **24175398.7**

(22) Date of filing: **13.05.2024**

(51) International Patent Classification (IPC):
**H03M 3/00** (2006.01)

(52) Cooperative Patent Classification (CPC):
**H03M 3/362; H03M 3/458**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **NXP B.V.**
**5656 AG Eindhoven (NL)**

(72) Inventors:
• **Burdiek, Bernard**
**5656 AG Eindhoven (NL)**
• **Rutten, Robert**
**5656 AG Eindhoven (NL)**

• **Brekelmans, Johannes Hubertus Antonius**
**5656 AG Eindhoven (NL)**
• **Bolatkale, Muhammed**
**5656 AG Eindhoven (NL)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire S051 9NJ (GB)**

Remarks:
Amended claims in accordance with Rule 137(2)
EPC.

(54) **A DETECTOR**

(57) A detector comprising: a filter arrangement configured to receive an output from a sigma-delta analogue to digital, SD-ADC, converter and generate a filtered output; a threshold comparison element configured to receive the filtered output and determine if signal content present in the filtered output is above or below a predetermined threshold, and wherein the detector is configured to, based on the determination of the threshold comparison element, output a flag signal indicative of a determination that the output of the SD-ADC is one of stable or unstable.

Figure 1

**Description**

**Field**

The present disclosure relates to a detector. In particular, it relates to a detector for determining the stability or instability of the output of a sigma delta analogue to digital convertor, SD-ADC.

**Backaround**

A SD-ADC can convert an analogue input signal to a digital output signal. Detecting when the operation of the SD-ADC is stable or unstable and thus when its output can be trusted or not trusted presents a challenge.

**Summary**

According to a first aspect of the present disclosure there is provided a detector comprising:

> a filter arrangement configured to receive an output from a sigma-delta analogue to digital, SD-ADC, converter and generate a filtered output;
> a threshold comparison element configured to receive the filtered output and determine if signal content present in the filtered output is above or below a predetermined threshold, and
> wherein the detector is configured to, based on the determination of the threshold comparison element, output a flag signal indicative of a determination that the output of the SD-ADC is one of stable or unstable.

In one or more examples, the filter arrangement is configured to attenuate outside a frequency range of interest, wherein the frequency range of interest is at frequencies greater than the bandwidth of the SD-ADC.
In one or more examples, the filter arrangement is configured to provide the filtered output such that it includes signal content comprising oscillations indicative of the instability of the SD-ADC on which the determination by the threshold comparison element is made. In one or more examples, the oscillations manifest at least when an input signal to the SD-ADC is at a peak level.
In one or more embodiments, the threshold comparison element is configured to determine if the signal content present in the filtered output is above the predetermined threshold and, if the signal content present in the filtered output is above the predetermined threshold, the detector is configured to output the flag signal to indicate that the output of the SD-ADC is unstable.
In one or more embodiments, the threshold comparison element is configured to determine if the signal content present in the filtered output is below the predetermined threshold and, if the signal content present in the filtered output is below the predetermined threshold, the detector is configured to output the flag signal to indicate that the output of the SD-ADC is stable.
In one or more embodiments, the filter arrangement is configured to filter the output from the SD-ADC outside of a predetermined frequency range of interest to generate the filtered output.
In one or more embodiments, the predetermined frequency range of interest is defined by [$f_{osc.min}$ ; $f_{osc.max}$], wherein:

$$f_{osc.min} = $$

$$\frac{f_s}{2\pi}\sqrt{\ln\left(z_{crit}(k_{r\,min})\right)}.\sqrt{\ln\left(z_{crit}(k_{r\,min})^*\right)}.\sqrt{1-\left(\frac{1}{2}\frac{\ln\left(z_{crit}(k_{r\,min})\right)+\ln\left(z_{crit}(k_{r\,min})^*\right)}{\sqrt{\ln\left(z_{crit}(k_{r\,min})\right)}.\sqrt{\ln\left(z_{crit}(k_{r\,min})^*\right)}}\right)^2}$$

$$f_{osc.ty} = $$

$$\frac{f_s}{2\pi}\sqrt{\ln\left(z_{crit}(k_{r\,typ})\right)}.\sqrt{\ln\left(z_{crit}\left(k_{r\,typ}\right)^*\right)}.\sqrt{1-\left(\frac{1}{2}\frac{\ln\left(z_{crit}(k_{r\,typ})\right)+\ln\left(z_{crit}\left(k_{r\,typ}\right)^*\right)}{\sqrt{\ln\left(z_{crit}(k_{r\,typ})\right)}.\sqrt{\ln\left(z_{crit}\left(k_{r\,typ}\right)^*\right)}}\right)^2}$$

and $f_{osc\,max} = 2. f_{osc\,typ} - f_{osc\,min} = f_{osc\,typ} + \Delta f,$
wherein $f_s$ comprises the sampling frequency of the SD-ADC; $z_{crit}$ is the complex argument of a noise transfer function, NTF(z,$k_r$), of a quantizer of the SD-ADC comprising a function of z, the complex argument of the transfer function, and $k_r$,

comprising the gain of the quanitzer, for one or more roots that leave a unit circle of a root locus plot of NTF(z, $k_r$) based on variation of $k_r$; and $k_{rtyp}$ comprises a typical quantizer gain of the quantizer of the SD-ADC and $k_{r\,min}$ is determined from the condition $|z_{\text{crit}}(k_{r\,min})| = 1$, wherein $k_{r\,min}$ corresponds to, or is based on, the quantizer gain at which the one or more roots leave the unit circle of the root locus plot.

In one or more embodiments, the filter arrangement comprises at least a first low pass filter configured to attenuate signal content in the output of the SD-ADC above the predetermined frequency range of interest to generate a first low pass filtered signal, wherein the filtered output is based on the first low pass filtered signal.

In one or more embodiments, the first low pass filter is implemented as a moving average filter.

In one or more embodiments, the filter arrangement includes a bandpass filter configured to attenuate signal content outside the predetermined frequency range of interest to generate a bandpass filtered signal, wherein the filtered output is based on the bandpass filtered signal.

In one or more embodiments, the filter arrangement comprises at least a first low pass filter configured to attenuate signal content in the output of the SD-ADC above the predetermined frequency range of interest to generate a first low pass filtered signal and wherein the filter arrangement is configured to provide the first low pass filtered signal to the bandpass filter for generating the bandpass filtered signal.

In one or more embodiments, the detector includes a magnitude determination element configured to receive the bandpass filtered signal as an input thereto and determine, as an output, a magnitude signal comprising one of a magnitude of, or a square of, the bandpass filtered signal for providing to the threshold comparison element.

In one or more embodiments, the filter arrangement includes a second low pass filter configured to receive the magnitude signal and output a further filtered signal, wherein the filtered output is based on the further filtered signal.

In one or more embodiments, the predetermined frequency range of interest is based on $f_{osc,typ}$, wherein

$$f_{osc.typ} =$$

$$\frac{f_s}{2\pi} \sqrt{\ln\left(z_{crit}\left(k_{r\,typ}\right)\right)} \cdot \sqrt{\ln\left(z_{crit}\left(k_{r\,typ}\right)^*\right)} \cdot \sqrt{1 - \left(\frac{1}{2}\frac{\ln\left(z_{crit}\left(k_{r\,typ}\right)\right) + \ln\left(z_{crit}\left(k_{r\,typ}\right)^*\right)}{\sqrt{\ln\left(z_{crit}\left(k_{r\,typ}\right)\right)} \cdot \sqrt{\ln\left(z_{crit}\left(k_{r\,typ}\right)^*\right)}}\right)^2}$$

wherein $f_s$ comprises the sampling frequency of the SD-ADC; $z_{\text{crit}}$ is the complex argument of a noise transfer function, NTF(z,$k_r$), of a quantizer of the SD-ADC comprising a function of z, the complex argument of the transfer function, and $k_r$, comprising the gain of the quantizer, for one or more roots that leave a unit circle of a root locus plot of NTF(z,kr) based on variation of $k_r$; and $k_{r\,typ}$ comprises a typical quantizer gain of the quantizer of the SD-ADC.

In one or more embodiments, the filter arrangement is configured to generate a filtered signal that includes signal content indicative of instability of the SD-ADC, based on the configuration of the SD-ADC.

In one or more embodiments, the detector includes a calibration mode in which parameters of the filter arrangement are adjustable to allow a user to identify the frequency range of interest based on control of the SD-ADC coupled to the detector.

According to a second aspect of the disclosure we provide a combination of an SD-ADC and the detector of the first aspect.

In one or more examples, the SD-ADC comprises an output terminal at which said output is provided, and wherein the combination includes a decimation chain coupled to the output terminal.

In one or more examples, the detector is also coupled to the output terminal.

In one or more examples, the filter arrangement comprises components shared with the decimation chain.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

**Brief Description of the Drawings**

One or more embodiments will now be described by way of example only with reference to the accompanying drawings in which:

Figure 1 shows an example embodiment of a detector and a SD-ADC;
Figure 2 shows a root locus plot and a corresponding magnitude plot of the NTF loop of the SD-ADC;
Figure 3 shows a second example embodiment of the detector;
Figure 4 shows a third example embodiment of the detector;
Figure 5 shows a fourth example embodiment of the detector; and
Figure 6 shows a fifth example embodiment of the detector which is partially integrated with components of the SD-ADC.

**Detailed Description**

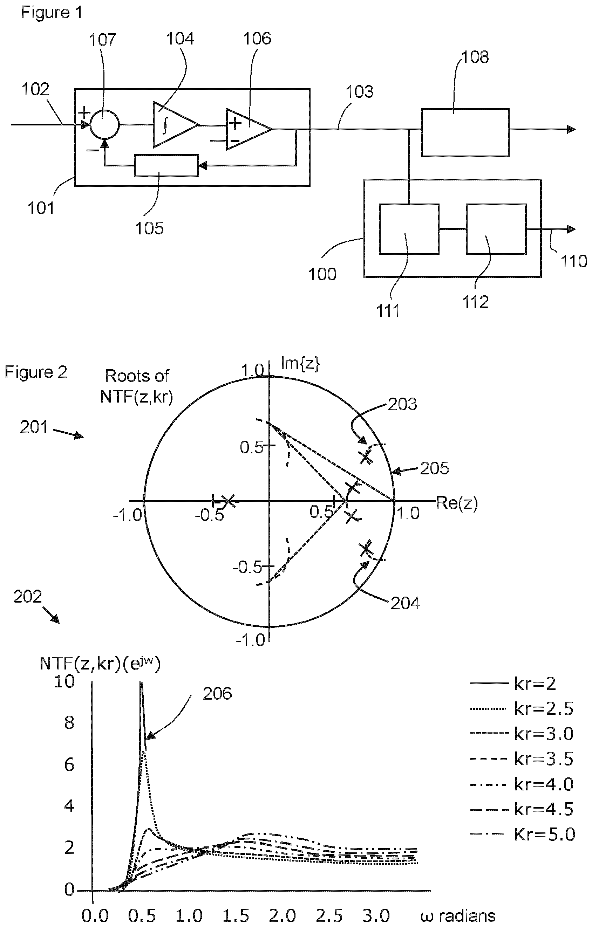

The following examples relate to a detector for determining the stability of a sigma delta analogue to digital converter (SD-ADC). Figure 1 shows a schematic diagram illustrating the detector 100 and the SD-ADC 101.

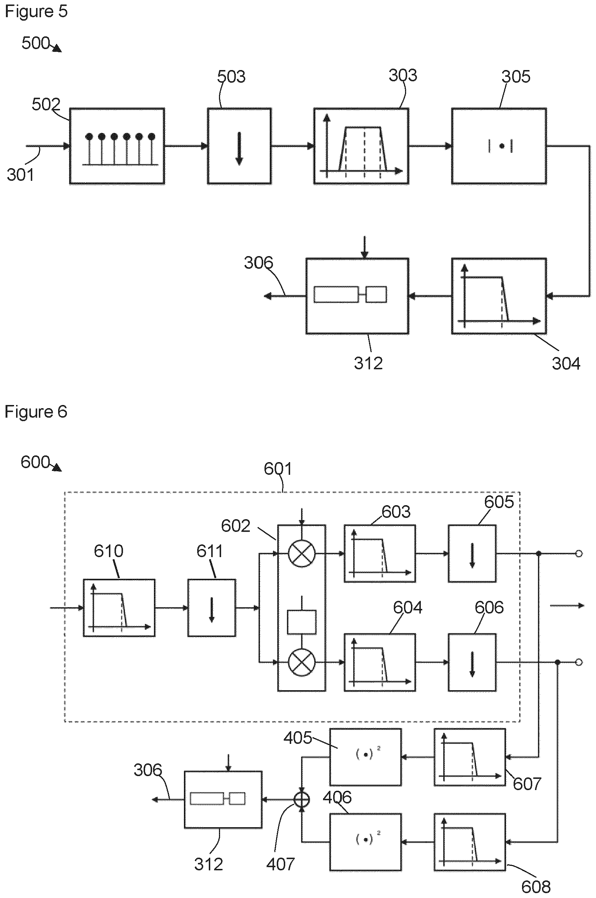

The SD-ADC 101 receives an analogue input signal at input 102 and provides a digital output signal at output 103, representing the digital, raw data stream or bit stream of the SD-ADC 101 at a sampling frequency $f_s$. The structure of a SD-ADC is not the focus of the present disclosure, but in general, the SD-ADC 101 comprises a modulator loop comprising an integrator or loop filter 104, a digital to analogue convertor, DAC, 105, a comparator or quantizer 106 and a difference element 107. The SD-ADC 101 of the present example comprises a Primary Decimation Chain, PDC, 108 which is a chain of one or more low-pass filters and one or more decimators (e.g. down samplers) needed to filter and decimate the bit stream at the output 103 of the SD-ADC 101 in order to recover the original analog input signal in a discretized form at a (e.g. lower) sampling rate. The PDC 108 is shown separately from the detector 100, connected to the output 103 in the example of Figure 1. However, since the detector 100 and the PDC 108 both comprise filters and have the bit stream from output 103 of the SD-ADC 101 as their input, an embodiment is disclosed (see figure 6) in which the filter components of the detector and PDC can be shared. In such an example, PDC 108 and detector 100 as shown in Figure 1 would appear at least partially merged.

As will be known to those skilled in the art, the primary decimation chain refers to an initial stage (or stages) in a multi-stage decimation process that acts on the bit stream from output 103 of the SD-ADC 101. This primary decimation chain is responsible for the first step of filtering and down-sampling of the oversampled and noise-shaped signal output by the SD-ADC 101. Its purpose is to reduce the (extremely) high data rate produced by the SD-ADC 101 modulator to a more manageable rate, while also beginning the process of noise reduction and signal extraction.

The detector 100 is connected to the output 103 of the SD-ADC 101 to receive the digital output signal of the SD-ADC 101 and is configured to detect, based on the waveform of the digital output signal or bit stream, when the SD-ADC 101 is stable and/or unstable or starts to be unstable. The detector 100 is configured to output a flag signal at output 110 indicative of the stability/instability of the SD-ADC 101. In general, the detector 100 comprises a filter arrangement 111 and a threshold comparison element 112. The filter arrangement 111 is configured to filter the output signal at 103 of the SD-ADC 101. The filtering delivers a frequency range of interest from the bit stream. It has been found that there is a frequency range of interest in the digital raw data stream where oscillations caused by instability of the SD-ADC 101 can be observed. The frequency range of interest, in the following examples, is at frequencies greater than the bandwidth of the SD-ADC. The threshold comparison element 112 is configured to determine if the signal content in the frequency range of interest, i.e. of the oscillations, is above or below a predetermined threshold. If one or more first conditions are met, including the signal content being above the threshold, then the detector 100 may output the flag signal that indicates a determination that the SD-ADC 101 is unstable. If one or more second conditions are met, including the signal content being below the threshold, then the detector 100 may output the flag signal that indicates a determination that the SD-ADC 101 is stable.

The frequency range of interest may depend on the components and configuration of the SD-ADC 101. The frequency range of interest may be determined by experiment, simulation, or calculation.

To provide more context, for all SD-ADCs the Maximum Stable Amplitude (MSA) level defines the point on a signal-to-noise (SNR) ratio curve of the SD-ADC from which the noise level grows faster than the input signal level. The increase in the noise is thought to be a result of the SD-ADC gradually becoming unstable, which presents as an abrupt drop of SNR for input levels greater than the MSA level. It has been realised that the unstable SD-ADC creates oscillations in the bit stream at output 103 of the SD-ADC, which are not easily observed directly from the bit stream, since $f_s$ is much higher than the frequency range of these oscillations. The output signal with these oscillations at output 103 are received by the PDC 108 and, at the output of the PDC 108, can be seen as an extra noise component, which manifest as signal spikes.

When the input signal at input 102 exceeds the MSA point, the DAC 105 is no longer able to provide sufficient instantaneous feedback causing an internal overload of the feedback or modulator loop present in the SD-ADC. As a result, the gain $k_r$ of the quantizer (noise gain) 106 is reduced (see formula 1).

$$NTF(z) = \frac{1}{1 + k_r \cdot LF(z)} \qquad (1)$$

The *NTF(z)* describes the discrete (quantization-)Noise Transfer Function from the input of the quantizer 106 to the output of the quantizer 106, where z is complex argument of the transfer function. The transfer function *LF(z)* describes the discrete transfer function from the input of the DAC 105 to the output of the loop filter 104. As will be familiar to those skilled in the art, the gain $k_r$ of the quantizer 106 when the MSA is not exceeded is simply the slope of a linear curve approximating the staircase shaped curve of the quantizer 106. Further, it will be familiar that both transfer functions *NTF(z)* and *LF(z)* result from a mathematical process called in the literature Impulse Invariant Transform, which transforms the time discrete impulse response of the components of the SD-ADC 101 (resulting from the sampling process at $f_s$) into the frequency domain.

The sum of input signal at input 102 and resultant signal noise generated in the SD-ADC can saturate the quantizer 106 of the SD-ADC, causing the quantizer 106 to drastically lose its original gain $k_r$ (noise gain).

Figure 2 shows a root locus plot 201 showing the roots of the Noise Transfer Function NTF($z,k_r$) as a function of complex z and $k_r$. It has been seen that the reduction of $k_r$ causes the critical pole pair shown as 203 and 204 of the noise transfer function, NTF($z,k_r$), to move out of the unit circle 205 of the root locus plot 201, which in turn causes the loop of SD-ADC 101 to become unstable. Thus, the critical pole pair comprises the roots of the Noise Transfer Function NTF($z,k_r$) that leave the unit circle 205, when the quantizer gain $k_r$ drops to much.

Figure 2 also shows a magnitude plot 202 of the noise transfer function NTF($z,k_r$). In particular, Figure 2 shows a plot 202 of the magnitude of the noise transfer function on the y-axis and frequency on the x-axis for different quantizer 106 gain levels, $k_r$. It has been found that the instability often manifests itself in the form of resonance shown by peak levels 206. The peak levels 206 are pronounced for lower levels of quantizer 106 gain, i.e. where $k_r$ is less than three in the example figure. These peak levels 206 correspond with the critical pole pair 203, 204 leaving the unit circle 205 with changes in gain kr.

The proposed stability detector 100 is configured to monitor the digital output signal or bit stream from output 103 to detect oscillations at a particular frequency range that has been found to be indicative of the peak levels 201 and the critical pole pair 203,204 leaving the unit circle 205 and, therefore, instability. In some examples, the detector 100 may be configured to generate, for each occurrence of such a signal spike above a threshold, a pulse signal, which is detected and counted in a bin corresponding to the level of the spike. The state of the bins may provide the information for the generation of the flag signal.

The combination of the SD-ADC 101 and the detector 100 may be part of a safety-critical application, such as an automotive radar receiver. It is desirable and sometimes even necessary to have a stability detector 100 coupled with the SD-ADC 100. The flag signal may thus by used to determine at what point the output from the SD-ADC 101 can no longer be trusted. In other examples, the flag signal may be used for calibration purposes to improve the MSA level by fine-tuning/calibrating coefficients of the components of the SD-ADC 101. It will be appreciated, however, that how the flag signal is used is not the main focus here and we instead disclose example embodiments of an advantageous detector 100 for evaluating the stability of the SD-ADC 101.

As seen in Figure 2, the frequencies around the peak levels 206 of the NTF represent the frequency range of interest. In particular, the frequencies around the peak levels 206 represent a frequency range of interest that has been found to contain oscillations that are indicative of instability occurring in the SD-ADC 100. Thus, the detector 100 is configured to, using the filter arrangement 111, filter the signal at the output 103 to isolate or give greater prominence to the signal content at the frequency range of interest. The filtering characteristics of the filter arrangement 111, such as bandwidth and centre frequency, depend on the SD-ADC design parameters.

We will now describe the filter arrangement 111 in more detail. In order to detect oscillations in the bit stream of an unstable ADC, which go on to manifest themselves as signal spikes at the output of the PDC 108, in this example, the bit stream is filtered with a low-pass filter. The signal spikes become more visible through the low-pass filtering. In some examples, the bit stream is filtered with a low-pass filter because, through the low-pass filtering process, the oscillations, which are without filtering hidden in the stream, become visible.

The low-pass filtering not only lets the oscillations become visible it also recovers the input signal from the bit stream. Therefore, the oscillations (which ultimately appear as signal spikes superimposed on the input signal at the PDC output 108) appear in the low-pass filtered bit stream as sporadic oscillations on the input signal. Whenever the recovered sinusoidal input signal passes through its maximum or minimum, sporadic oscillations can occur on the input signal if the SD-ADC 101 is unstable. Thus, whenever the input signal (as seen in the filtered output from 103) has passed through a maximum or minimum, the oscillations die out quickly as the input signal becomes smaller and the critical pole pair 203, 204 of the SD-ADC returns to the stable area within the unit circle 205.

In the present example, in order to be able to use the number of these sporadic oscillations as a detection criterion for unstable behavior of the SD-ADC, they are first extracted from the low-pass filtered bit stream using a bandpass filter.

Thus, in the present example, the filter arrangement 111 comprises a low-pass filter and a bandpass filter. The bandpass filter is configured to remove the actual input signal of the SD-ADC, as seen in the output signal at 103, and therefore provides only the sporadic oscillations at its output. The pass band of the bandpass filter must be chosen in such a way that it covers the frequency range [$f_{osc,min}$ ; $f_{osc,max}$] comprising where the sporadic oscillations occur, wherein $f_{osc,min}$ represents a lower frequency limit where the oscillations are observed and $f_{osc,max}$ represents a higher frequency limit where the oscillations are observed. The cutoff frequency, $f_c$, of the low pass filter is set to $f_c >= f_{osc\_max}$ in the present example in order to cover the full range of frequencies at which the oscillations are seen to occur. It has been found that when $f_c$ is chosen too small, the oscillations in the frequency range of interest are filtered out and only noise spikes are visible. If $f_c$ is chosen too large, the detector 100 will be too sensitive due to too much inherent variation in the signal. It may be necessary to fine tune the cut off frequency to suit the behaviour of the SD-ADC to which the detector 100 is coupled.

The frequency range for the sporadic oscillations can be determined via simulations experimentally from the raw data stream. A good starting point for $f_{osc,max}$ is the frequency where the peak level 206 is observed.

However, it is also possible to determine the frequency range of the bandpass filter [$f_{osc,min}$ ; $f_{osc,max}$] directly via the two points on the root locus plot, $z_{crit}(k_r)$ of the critical pole pair 203, 204. The root locus curves $z(k_r)$ (dashed lines in plot 201) describe the zeros of the denominator (see equation 2 and equation 1) of the noise transfer function NTF(z) as a function of the quantizer gain $k_r$. The critical pole pair [$z_{crit}$, $z_{crit}{}^*$] shown as 203, 204 represents the two poles of the noise transfer function NTF(z) whose root locus curves [$z_{crit}(k_r)$, $z_{crit}(k_r){}^*$] leave, with decreasing quantizer gain $k_r$, the unit circle 205 and thus lead to instability of the SD-ADC 101.

$$0 = 1 + k_r \cdot LF\left(z(k_r)\right) \quad (2)$$

Thus, $f_{osc,min}$ and $f_{osc,max}$ may be determined using the following equations.

$$f_{osc,min} = \frac{f_s}{2\pi} \cdot \sqrt{\ln\left(z_{crit}(k_{r,min})\right)} \cdot \sqrt{\ln\left(z_{crit}(k_{r,min}){}^*\right)} \cdot \sqrt{1 - \left(\frac{1}{2} \cdot \frac{\ln\left(z_{crit}(k_{r,min})\right) + \ln\left(z_{crit}(k_{r,min}){}^*\right)}{\sqrt{\ln\left(z_{crit}(k_{r,min})\right)} \cdot \sqrt{\ln\left(z_{crit}(k_{r,min}){}^*\right)}}\right)^2}$$

$$(3)$$

$$f_{osc,typ} = \frac{f_s}{2\pi} \cdot \sqrt{\ln\left(z_{crit}(k_{r,typ})\right)} \cdot \sqrt{\ln\left(z_{crit}(k_{r,typ}){}^*\right)} \cdot \sqrt{1 - \left(\frac{1}{2} \cdot \frac{\ln\left(z_{crit}(k_{r,typ})\right) + \ln\left(z_{crit}(k_{r,typ}){}^*\right)}{\sqrt{\ln\left(z_{crit}(k_{r,typ})\right)} \cdot \sqrt{\ln\left(z_{crit}(k_{r,typ}){}^*\right)}}\right)^2}$$

$$(4)$$

$$f_{osc,max} = 2 \cdot f_{osc,typ} - f_{osc,min} = f_{osc,typ} + \Delta f \quad (5)$$

In order to determine the center frequency $f_{osc,typ}$ and the lower corner frequency $f_{osc,min}$ of the bandpass filter using the formulas (4) and (3), the root locus curve $z_{crit}(k_r)$ is first calculated numerically using formula (2). After that the quantizer gain $k_{r,min}$ is determined from the condition $|z_{crit}(k_{r,min})| = 1$, where $k_{r,min}$ corresponds to, or is based on, the quantizer gain at which the critical pole pair leaves the unit circle. The complex value $z_{crit}(k_{r,typ})$ is simply the critical pole at the typical quantizer gain $k_r$. In the last step of this example process, the upper corner $f_{osc,max}$ is calculated from formula (5). All parameters of the filter arrangement 111 are now determined from the critical pole pair of the NTF.

Thus, to summarise, it has been found that an indicator of the SD-ADC exceeding its Maximum Stable Amplitude manifests as signal spikes at the output of the PDC 108 or as "oscillations" that are observable in the digital output signal from the output 103 of the SD-ADC at a frequency range of interest, wherein the upper limit of the frequency range is defined as $f_{osc,max}$, and a lower limit of the frequency range is defined as $f_{osc,min}$. The values of $f_{osc,min}$ and $f_{osc,max}$ may be used to define the filtering performed by the filter arrangement 111. The values of $f_{osc,min}$ and $f_{osc,max}$ may be determined experimentally by looking for the occurrence of the disclosed oscillations at times of instability or by calculation using equations 2-5. The unstable behavior caused by the SD-ADC 101 exceeding its Maximum Stable Amplitude may be understood as a critical pole pair ($z_{crit}$, $z_{crit}{}^*$) of the SD-ADC 101 leaving the unit circle of a root locus plot 201. It has been seen that where the critical pole pair ($z_{crit}$, $z_{crit}{}^*$) 203, 204 leave the unit circle 205, an oscillation builds up that corresponds to the frequency of the critical pole. Since the critical pole pair moves back into the unit circle as the input signal at input 102 decreases, the oscillation frequency changes slightly and the oscillation dies out after a short time, but can be detected with the filtering described.

We will now describe several embodiments showing the structure of the detector 100 in more detail.

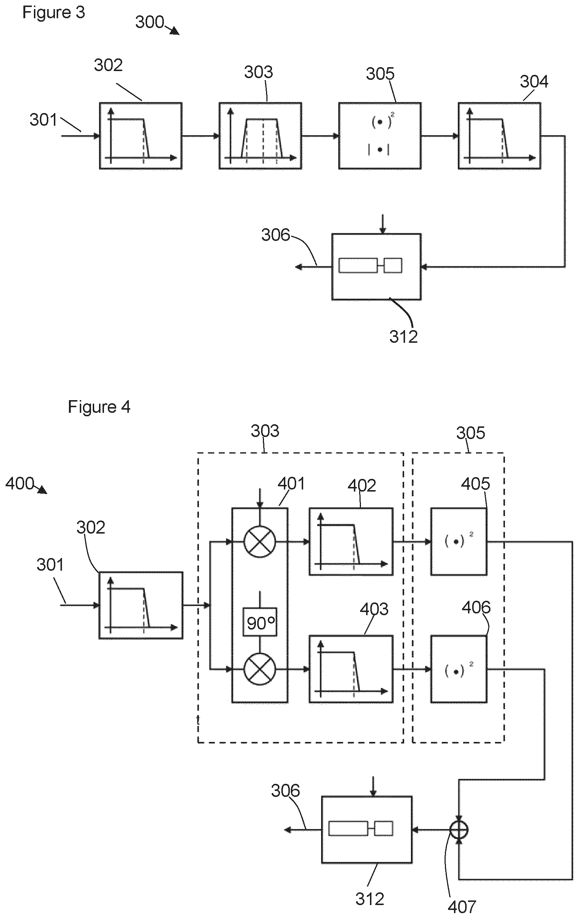

Figure 3 shows an embodiment of the detector 300 comprising an input 301 configured to receive the bit stream, from output 103, of the SD-ADC 101. The filter arrangement 111 shown in Figure 1 is embodied as a plurality of filters in the example of figure 3. Firstly, the output of the SD-ADC 101 is received by a first low pass filter 302. As mentioned above, the first low pass filter 302 may be considered to make the oscillations we are trying to detect visible in the bit stream. In some examples, this low pass filter 302 may be combined with a decimation element to lower the sample rate. The low pass filtered output of the first low pass filter 302 is provided to a bandpass filter 303. The bandpass filter 303 may be considered to extract the oscillations from the low pass filtered signal, wherein the low pass filtered signal comprises the input signal 102 having passed through the SD-ADC in combination with the oscillations (if the SD-ADC has become unstable). The bandpass filtered output of the bandpass filter 303 is provided to a second low pass filter 304, via a magnitude determination element 305. The magnitude determination element 305 may be configured to determine the square of its input and provide the squared output to the second low pass filter 304. In other examples, the magnitude determination element 305 may be configured to apply an absolute value function to its input and provide the absolute value to the second low pass filter 304. The further low pass filtered output of the second low pass filter 304 is provided to a threshold comparison element 312. The squaring or absolute value operation together with the second low-pass filter 304 is provided to create a detectable pulse signal from the sporadic oscillations. The threshold comparison element 312 is configured to receive the filtered output of the filter arrangement, comprising the filtering by the first low pass filter 302, the bandpass filter 303 and the second low pass filter 304 (including the magnitude determination element 305).

The threshold comparison element 312 may be understood as being configured to evaluate the signal content or pulses in the frequency range of interest that was isolated by the filtering. The threshold comparison element 312 is configured to generate a flag signal at output 306 indicative of when a determination is made that the SD-ADC is one or both of stable or unstable due to exceeding its MSA. The generation of the flag signal is based on the filtered output of the filter arrangement meeting one or more conditions including a comparison to a predetermined threshold by the threshold comparison element 312.

Thus, put another way, the detector 300 may be considered to include a signal conditioner 305, 304 that receives a signal representing the oscillations from the bandpass filter 303 and generates a signal containing pulses based on when the oscillations are present. The threshold comparison element 312 receives the pulse signal. Thus, the threshold comparison element 312 may be considered to count pulses in the signal from the signal conditioner that meet one or more conditions and, based on the count, generate the flag signal.

In this example, the configuration of the bandpass filter 303 may be based on a typical oscillation frequency $f_{osc,typ}$, as defined above, of the critical pole pair 203, 204.

Thus, $f_{osc,typ}$ may be used as the center frequency of the bandpass filter 303. The upper and lower cutoff frequencies ($f_{c1,bp}$ and $f_{c2,bp}$) of the bandpass filter 303 may be defined as:

$$f_{c1,bp} = f_{osc,typ} - \Delta f \qquad (6)$$

$$f_{c2,bp} = f_{osc,typ} + \Delta f \qquad (7)$$

The value of $\Delta f$ is chosen in such a way that $f_{c1,bp}$ includes the minimum and $f_{c2,b2}$ includes the maximum oscillation frequencies that occur due to the MSA being exceeded. This may be determined by experimentation, simulation or estimate.

The configuration of the cut off frequency of the first low pass filter 302 comprises or is based on $f_{osc,typ} + \Delta f$, which may be substantially equal to $f_{osc,max}$ in some examples.

The magnitude determination element 305 may be configured to apply a square, $(\cdot)^2$, function or a magnitude, $|\cdot|$, function.

The configuration of the cut off frequency of the second low pass filter 304 may be configured such that the cutoff frequency $f_c$ is set to the bandwidth $f_{bw}$ of the SD-ADC ($f_c=f_{bw}$) or is based on the bandwidth of the SD-ADC.

As mentioned above, the second low-pass filter is provided in order to create a pulse signal from the RMS output signal of the magnitude determination element 305. The pulse signal, which represents the energy of one sporadic oscillation event, is delivered to the threshold comparison element 312.

The threshold comparison element 312 of the present example is configured to, using a counter, count the pulse signals that exceed a predetermined threshold level. If the counter reaches a predetermined limit, such as within a predetermined time period, the flag signal is generated. In other examples, signal energy may be determined over a predetermined time. In general, the threshold comparison element 312 measures the (e.g. number of sporadic oscillation events in the) signal content in the frequency range of interest and, based on that measure exceeding a threshold, generates the flag signal.

A third example detector 400 is shown in Figure 4. In this example, the same reference numerals have been used for like parts. The main difference in this example is that the bandpass filter 303 and the second low pass filter 304 are implemented differently, which may save integrated circuit area. In this example the bandpass filter is realized as a complex bandpass filter comprising a half complex mixer followed by a lowpass filter.

Thus, the bandpass filter 303 and the second low pass filter 304 in the previous embodiment are embodied in detector 400 as a complex filter, which is implemented by a half-complex mixer 401 to receive the low pass filtered output of the first low pass filter 302 and two low pass filters 402, 403. The half-complex mixer 401 is configured to provide two outputs comprising I and Q components of the output of the first low pass filter 302 mixed with a clock signal having a frequency $f_{mix}$ based on a negative of $f_{osc,typ}$. The mixing operation with $f_{mix}=-f_{osc,typ}$ is configured to shift the oscillation frequency range of interest to frequencies around zero (DC), where $f_{osc,typ}$ may be shifted to zero. The detector 400 is configured to filter the I component by a first-component-low pass filter 402 and is configured to filter the Q component by a second-component-low pass filter 403. Due to the frequency shift operation of the digital mixer, which shifts the frequency range of interest to DC, the low-pass filter 304 in the previous example - needed for the pulse creation - is here, in principle, not needed.

The first-component-low pass filter 402 and the second-component-low pass filter 403 have a cutoff frequency based on $\Delta f$, that is the half the bandwidth of the oscillation frequency range, since due to the complex nature of the filter also negative frequencies are taken into account.

The magnitude determination element 305 in the present example comprises a first magnitude determination element 405 configured to apply a square function to the output of the first-component-low pass filter 402, and a second magnitude determination element 406 configured to apply a square function to the output of the second-component-low pass filter 403. Thus, in this example, the magnitude determination element 305 comprises a squarer.

The detector 400 further comprises an adder 407 to sum the squared outputs of the first magnitude determination element 405 and the second magnitude determination element 406. The summing element 407 represents the process of creating a squared complex number from the two real paths.

The summed output of the adder 407 is provided to the threshold comparison element 312.

Due to the complex nature of the filter in this embodiment, the cut off frequency of the first-component-low pass filter 402 and the second-component-low pass filter 403 are used to extract the oscillations, which, in the previous example is comparable to defining the bandwidth of the bandpass filter 303. As mentioned above, the first-component-low pass filter 402 and the second-component-low pass filter 403 may have a cutoff frequency comprising $\Delta f$. A center frequency of the complex bandpass filter 303 is defined by the frequency of the mixed clock signal and in some examples comprises

$$fmix = -f_{osc,typ}.$$

A fourth example detector 500 is shown in figure 5. The detector 500 (and any other detector shown herein) may be suitable for FM and DAB radio standards. In this example, the first low pass filter 302 is embodied as a moving average filter 502 and an optional decimator 503. The moving average filter averages over a plurality, N, of recent samples. The value of N may be determined by

$$N = Round\left[\frac{f_s}{2 \cdot f_{osc,max}}\right]$$

In the present example, the number of samples or "taps" N of the moving average filter was calculated as N=12. The value of $\Delta f$ was chosen to be 60MHz. The minimum oscillation frequency $f_{osc,min}$ was determined to be approximately 170 MHz. This choice of $\Delta f$ was based on the frequency range of interest plus a margin and to have the largest in-band frequency of SD-ADC in the stopband of the bandpass filter. The cutoff frequency of the second low pass filter 304 was set to the bandwidth of the SD-ADC 101, which in this example case was 110 MHz.

The present example includes an optional decimator 503 having a decimation factor of, in this example, eight (M=8). The decimation is provided in order to relax the requirements for the clock speed of the bandpass filter 303 and the second lowpass filter 304. Thus, the decimation is performed on the output from the moving average filter 502, which runs at the sampling rate of the SD-ADC, $f_s$.

In the example detector 500, the bandpass filter 303 and the second lowpass filter 304 may be implemented as Tschebyscheff filters with a stopband attenuation of 60dB, for example.

A fifth example detector 600 is shown in figure 6. It is based on the detector 400 of figure 4.

The detector 600 uses hardware already present in the PDC 108 coupled to the SD-ADC 101 to implement at least part of the filter arrangement 111.

In particular, the detector 600 is embodied using components of the existing PDC 601 of the SD-ADC 101. The SD-ADC 101 in the present example is configured to support DAB radio. Thus, the cutoff frequencies of the complex PDC bandpass filter needed for reception of a DAB signal happen to be ($f_{c,lp1}$=240MHz, $f_{c,lp2}$=45MHz= $\Delta f$) very similar to the filter frequencies required for detecting oscillations as described above.

Thus, the half complex mixer 401 of detector 400 is embodied as the mixer 602 of the PDC, which is configured to mix with a clock signal at $f_{mix}$=-$f_{osc,min}$. Besides the mixing frequencies for FM and DAB reception this extra mixing frequency ($f_{mix=}$-$f_{osc,min}$) has to be added as extra mixing mode to the half complex mixer of the PDC. The choice of setting $f_{mix}$ to -$f_{osc,min}$ and not to - $f_{osc,typ}$ means that the oscillation frequency range of interest, which we want to detect, is shifted only into the positive frequency range of the complex bandpass filter. Although the negative frequency range of the complex filter remains unused and oscillation frequencies above $f_{osc,typ}$ are already suppressed by the lowpass filters 603 and 604, this choice of $f_{mix}$ has the advantage that the detector signal does not contain any DC content. The first-component-low pass filter 402 and the second-component-low pass filter 403 of detector 400 are embodied as the first-component-low pass filter 603 and the second-component-low pass filter 604 of the PDC 601. An optional first decimator 605 of the PDC 601 receives the output of the first-component-low pass filter 603. An optional second decimator 606 of the PDC 601 receives the output of the second-component-low pass filter 604. The output of the first decimator 605 then leaves the PDC 601 and is provided to components of the detector 600 which are distinct from the SD-ADC 101. In particular, the detector 600 includes a low pass filter 607 configured to filter out all frequency components of the input signal of the SD-ADC, which are mixed up by $f_{mix}$ and have been found to disturb the processing of the much smaller oscillation frequencies. If, for the stability test of the SD-ADC, a DC signal is used (which happens to provide a worst case signal for stability) the frequency, that should be particularly suppressed by the low-pass filter 607 is the mixer frequency $f_{mix}$ itself. The low pass-filter 607 is necessary in cases, where the upconverted based band signal (input signal of the SD-ADC) would not have been suppressed enough by the low-pass filter 603.

Likewise, the output of the second decimator 606 then leaves the PDC 601 and is provided to components of the detector 600 which are distinct from the SD-ADC 101 and PDC 601. In particular, the detector 600 includes a low pass filter 608 configured to filter out (further supress) any signal content at the mixing frequency $f_{mix}$ and above. Thus, the low pass filter 608 is performing a different function to, say, low pass filter 304. The first magnitude determination element 405 and the second magnitude determination element 406 are configured to receive the output from a respective one of the low pass filters 607, 608. The adder 407 adds the outputs of the first magnitude determination element 405 and the second magnitude determination element 406 and provides the resultant summed signal to the threshold comparison element 312.

The PDC 601 further comprises a decimation filter 610 and a decimator 611 prior to the mixer 602.

The frequency of the mixing clock signal for the mixer 602 comprises a quarter of the digital clock frequency $f_d$ of the SD-ADC 101 ($f_{mix}$=-$f_d$/4), which was found to correspond approximately to the minimum oscillation frequency $f_{osc,min}$. Such a $f_d$/4 mixer can be implemented in an efficient way in the digital domain because it will only multiply by 0, -1 or +1 values.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A detector comprising:

   a filter arrangement configured to receive an output from a sigma-delta analogue to digital, SD-ADC, converter and generate a filtered output;
   a threshold comparison element configured to receive the filtered output and determine if signal content present in the filtered output is above or below a predetermined threshold, and
   wherein the detector is configured to, based on the determination of the threshold comparison element, output a flag signal indicative of a determination that the output of the SD-ADC is one of stable or unstable.

   The frequency range of interest, in the following examples, is at frequencies greater than the bandwidth of the SD-ADC.

2. The detector of claim 1, wherein the threshold comparison element is configured to determine if the signal content present in the filtered output is above the predetermined threshold and, if the signal content present in the filtered output is above the predetermined threshold, the detector is configured to output the flag signal to indicate that the output of the SD-ADC is unstable.

3. The detector of claim 1 or claim 2, wherein the threshold comparison element is configured to determine if the signal content present in the filtered output is below the predetermined threshold and, if the signal content present in the filtered output is below the predetermined threshold, the detector is configured to output the flag signal to indicate that the output of the SD-ADC is stable.

4. The detector of any preceding claim, wherein the filter arrangement is configured to filter the output from the SD-ADC outside of a predetermined frequency range of interest to generate the filtered output.

5. The detector of claim 4, wherein the predetermined frequency range of interest is defined by $[f_{osc.min} ; f_{osc.max}]$, wherein:

$$f_{osc.min} =$$

$$\frac{f_s}{2\pi}\sqrt{\ln\left(z_{crit}(k_{r\,min})\right)}.\sqrt{\ln\left(z_{crit}(k_{r\,min})^*\right)}.\sqrt{1 - \left(\frac{1}{2}\frac{\ln\left(z_{crit}(k_{r\,min})\right)+\ln\left(z_{crit}(k_{r\,min})^*\right)}{\sqrt{\ln\left(z_{crit}(k_{r\,min})\right)}.\sqrt{\ln\left(z_{crit}(k_{r\,min})^*\right)}}\right)^2}$$

$$f_{osc.typ} =$$

$$\frac{f_s}{2\pi}\sqrt{\ln\left(z_{crit}(k_{r\,typ})\right)}.\sqrt{\ln\left(z_{crit}\left(k_{r\,typ}\right)^*\right)}.\sqrt{1 - \left(\frac{1}{2}\frac{\ln\left(z_{crit}(k_{r\,typ})\right)+\ln\left(z_{crit}\left(k_{r\,typ}\right)^*\right)}{\sqrt{\ln\left(z_{crit}(k_{r\,typ})\right)}.\sqrt{\ln\left(z_{crit}\left(k_{r\,typ}\right)^*\right)}}\right)^2}$$

and $f_{osc\,max} = 2.f_{osc\,typ} - f_{osc\,min} = f_{osc\,typ} + \Delta f$,
wherein $f_s$ comprises the sampling frequency of the SD-ADC; $z_{crit}$ is the complex argument of a noise transfer function, NTF$(z,k_r)$, of a quantizer of the SD-ADC comprising a function of $z$, the complex argument of the transfer function, and $k_r$, comprising the gain of the quanitzer, for one or more roots that leave a unit circle of a root locus plot of NTF$(z, k_r)$ based on variation of $k_r$; and $k_{r\,typ}$ comprises a typical quantizer gain of the quantizer of the SD-ADC and $k_{r\,min}$ is determined from the condition $|z_{crit}(k_{rmin})| = 1$, wherein $k_{rmin}$ corresponds to, or is based on, the quantizer gain at which the one or more roots leave the unit circle of the root locus plot.

6. The detector of claim 4, wherein the filter arrangement comprises at least a first low pass filter configured to attenuate signal content in the output of the SD-ADC above the predetermined frequency range of interest to generate a first low pass filtered signal, wherein the filtered output is based on the first low pass filtered signal.

7. The detector of claim 6, wherein the first low pass filter is implemented as a moving average filter.

8. The detector of claim 4, wherein the filter arrangement includes a bandpass filter configured to attenuate signal content outside the predetermined frequency range of interest to generate a bandpass filtered signal, wherein the filtered output is based on the bandpass filtered signal.

9. The detector of claim 8, wherein the filter arrangement comprises at least a first low pass filter configured to attenuate signal content in the output of the SD-ADC above the predetermined frequency range of interest to generate a first low pass filtered signal and wherein the filter arrangement is configured to provide the first low pass filtered signal to the bandpass filter for generating the bandpass filtered signal.

10. The detector of claim 8 or claim 9, wherein the detector includes a magnitude determination element configured to receive the bandpass filtered signal as an input thereto and determine, as an output, a magnitude signal comprising one of a magnitude of, or a square of, the bandpass filtered signal for providing to the threshold comparison element.

11. The detector of claim 10, wherein the filter arrangement includes a second low pass filter configured to receive the magnitude signal and output a further filtered signal, wherein the filtered output is based on the further filtered signal.

12. The detector of claim 4, wherein the predetermined frequency range of interest is based on $f_{osc,typ}$, wherein

$$f_{osc.ty} = \frac{f_s}{2\pi}\sqrt{\ln\left(z_{crit}(k_{r\,typ})\right)}.\sqrt{\ln\left(z_{crit}(k_{r\,typ})^*\right)}.\sqrt{1-\left(\frac{1}{2}\frac{\ln\left(z_{crit}(k_{r\,typ})\right)+\ln\left(z_{crit}(k_{r\,typ})^*\right)}{\sqrt{\ln\left(z_{crit}(k_{r\,typ})\right)}.\sqrt{\ln\left(z_{crit}(k_{r\,typ})^*\right)}}\right)^2}$$

wherein $f_s$ comprises the sampling frequency of the SD-ADC; $z_{crit}$ is the complex argument of a noise transfer function, $NTF(z,k_r)$, of a quantizer of the SD-ADC comprising a function of z, the complex argument of the transfer function, and $k_r$, comprising the gain of the quantizer, for one or more roots that leave a unit circle of a root locus plot of $NTF(z,kr)$ based on variation of $k_r$; and $k_{r\,typ}$ comprises a typical quantizer gain of the quantizer of the SD-ADC.

13. The detector of claim 1, wherein the filter arrangement is configured to generate a filtered signal that includes signal content indicative of instability of the SD-ADC, based on the configuration of the SD-ADC.

14. The detector of claim 4, wherein the detector includes a calibration mode in which parameters of the filter arrangement are adjustable to allow a user to identify the frequency range of interest based on control of the SD-ADC coupled to the detector.

15. A combination of an SD-ADC and the detector of any preceding claim.

**Amended claims in accordance with Rule 137(2) EPC.**

1. A detector comprising:

   a filter arrangement (111) configured to receive an output (103) from a sigma-delta analogue to digital, SD-ADC, converter (101) and generate a filtered output; and
   a threshold comparison element (112) configured to receive the filtered output and determine if signal content present in the filtered output is above or below a predetermined threshold;
   wherein the detector is configured to, based on the determination of the threshold comparison element, output a flag signal indicative of a determination that the output of the SD-ADC is one of stable or unstable,

**characterised in that** the filter arrangement is configured to filter the output from the SD-ADC outside of a predetermined frequency range of interest to generate the filtered output, wherein the frequency range of interest is at frequencies greater than the bandwidth of the SD-ADC

and wherein the filter arrangement includes a bandpass filter (303) configured to attenuate signal content outside the predetermined frequency range of interest to generate a bandpass filtered signal, wherein the filtered output is based on the bandpass filtered signal.

2. The detector of claim 1, wherein the threshold comparison element is configured to determine if the signal content present in the filtered output is above the predetermined threshold and, if the signal content present in the filtered output is above the predetermined threshold, the detector is configured to output the flag signal to indicate that the output of the SD-ADC is unstable.

3. The detector of claim 1 or claim 2, wherein the threshold comparison element is configured to determine if the signal content present in the filtered output is below the predetermined threshold and, if the signal content present in the filtered output is below the predetermined threshold, the detector is configured to output the flag signal to indicate that the output of the SD-ADC is stable.

4. The detector of any preceding claim, wherein the predetermined frequency range of interest is defined by $[f_{osc.min} ; f_{osc.max}]$, wherein:

$$f_{osc.min} =$$

$$\frac{f_s}{2\pi} \sqrt{\ln\left(z_{crit}(k_{r\,min})\right)} \cdot \sqrt{\ln\left(z_{crit}(k_{r\,min})^*\right)} \cdot \sqrt{1 - \left(\frac{1}{2}\frac{\ln\left(z_{crit}(k_{r\,min})\right)+\ln\left(z_{crit}(k_{r\,min})^*\right)}{\sqrt{\ln\left(z_{crit}(k_{r\,min})\right)}\cdot\sqrt{\ln\left(z_{crit}(k_{r\,min})^*\right)}}\right)^2}$$

$$f_{osc.typ} =$$

$$\frac{f_s}{2\pi} \sqrt{\ln\left(z_{crit}(k_{r\,typ})\right)} \cdot \sqrt{\ln\left(z_{crit}(k_{r\,typ})^*\right)} \cdot \sqrt{1 - \left(\frac{1}{2}\frac{\ln\left(z_{crit}(k_{r\,typ})\right)+\ln\left(z_{crit}(k_{r\,typ})^*\right)}{\sqrt{\ln\left(z_{crit}(k_{r\,typ})\right)}\cdot\sqrt{\ln\left(z_{crit}(k_{r\,typ})^*\right)}}\right)^2}$$

and $f_{osc\,max} = 2 \cdot f_{osc\,typ} - f_{osc\,min} = f_{osc\,typ} + \Delta f$,

wherein $f_s$ comprises the sampling frequency of the SD-ADC; $z_{crit}$ is the complex argument of a noise transfer function, NTF$(z,k_r)$, of a quantizer of the SD-ADC comprising a function of z, the complex argument of the transfer function, and $k_r$, comprising the gain of the quanitzer, for one or more roots that leave a unit circle of a root locus plot of NTF$(z, k_r)$ based on variation of $k_r$; and $k_{r\,typ}$ comprises a typical quantizer gain of the quantizer of the SD-ADC and $k_{r\,min}$ is determined from the condition $|z_{crit}(k_{r\,min})| = 1$, wherein $k_{r\,min}$ corresponds to, or is based on, the quantizer gain at which the one or more roots leave the unit circle of the root locus plot.

5. The detector of any preceding claim, wherein the filter arrangement comprises at least a first low pass filter (302) configured to attenuate signal content in the output of the SD-ADC above the predetermined frequency range of interest to generate a first low pass filtered signal, wherein the filtered output is based on the first low pass filtered signal.

6. The detector of claim 5, wherein the first low pass filter is implemented as a moving average filter.

7. The detector of any preceding claim, wherein the detector includes a magnitude determination element configured to receive the bandpass filtered signal as an input thereto and determine, as an output, a magnitude signal comprising one of a magnitude of, or a square of, the bandpass filtered signal for providing to the threshold comparison element.

8. The detector of claim 7, wherein the filter arrangement includes a second low pass filter configured to receive the magnitude signal and output a further filtered signal, wherein the filtered output is based on the further filtered signal.

9. The detector of any preceding claim, wherein the predetermined frequency range of interest is based on $f_{osc,typ}$, wherein

$$f_{osc.typ} =$$

$$\frac{f_s}{2\pi} \sqrt{\ln\left(z_{crit}(k_{r\ typ})\right)} \cdot \sqrt{\ln\left(z_{crit}(k_{r\ typ})^*\right)} \cdot \sqrt{1 - \left(\frac{1}{2}\frac{\ln\left(z_{crit}(k_{r\ typ})\right) + \ln\left(z_{crit}(k_{r\ typ})^*\right)}{\sqrt{\ln\left(z_{crit}(k_{r\ typ})\right)} \cdot \sqrt{\ln\left(z_{crit}(k_{r\ typ})^*\right)}}\right)^2}$$

wherein $f_s$ comprises the sampling frequency of the SD-ADC; $z_{crit}$ is the complex argument of a noise transfer function, NTF($z,k_r$), of a quantizer of the SD-ADC comprising a function of $z$, the complex argument of the transfer function, and $k_r$, comprising the gain of the quantizer, for one or more roots that leave a unit circle of a root locus plot of NTF($z,kr$) based on variation of $k_r$; and $k_{r\ typ}$ comprises a typical quantizer gain of the quantizer of the SD-ADC.

10. The detector of claim 1, wherein the filter arrangement is configured to generate a filtered signal that includes signal content indicative of instability of the SD-ADC, based on the configuration of the SD-ADC.

11. The detector of any preceding claim, wherein the detector includes a calibration mode in which parameters of the filter arrangement are adjustable to allow a user to identify the frequency range of interest based on control of the SD-ADC coupled to the detector.

12. A combination of an SD-ADC and the detector of any preceding claim.

Figure 1

Figure 2

Roots of
NTF(z,kr)

Figure 3

Figure 4

Figure 5

Figure 6

## EUROPEAN SEARCH REPORT

**Application Number**

EP 24 17 5398

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/084924 A1 (CUSINATO PAOLO [IT] ET AL) 4 July 2002 (2002-07-04) | 1-4,15 | INV. H03M3/00 |
| A | * paragraph [0018] * <br> * paragraphs [0024] - [0026] * <br> * paragraph [0030] * <br> * paragraph [0064] * <br> * figures 2,3A,3B * | 8-11 | |
| X | CUSINATO P ET AL: "Digital Technique for Instability Detection and Saturation Recovery in High-Order SC [Sigma][Delta] Modulators", ANALOG INTEGRATED CIRCUITS AND SIGNAL PROCESSING, KLUWER ACADEMIC PUBLISHERS, BO, vol. 36, no. 1-2, July 2003 (2003-07), pages 7-19, XP019203871, ISSN: 1573-1979, DOI: 10.1023/A:1024481126518 | 1-5, 12-15 | |
| A | * page 8, left-hand column, last paragraph - right-hand column, paragraph 1 * <br> * page 13, left-hand column, paragraph 1 * <br> * page 13, right-hand column, paragraph 1 * <br> * abstract; figures 1-4,8-10 * | 8-11 | TECHNICAL FIELDS SEARCHED (IPC) <br><br> H03M |
| X | US 2015/194975 A1 (MIAILLE GERALD [GB] ET AL) 9 July 2015 (2015-07-09) | 1-4,6,7,15 | |
| A | * paragraph [0001] * <br> * paragraphs [0060] - [0063] * <br> * figures 6,8 * | 8-11 | |
| X | DE 10 2007 013255 A1 (BOSCH GMBH ROBERT [DE]) 25 September 2008 (2008-09-25) | 1-4,6,7,15 | |
| A | * paragraph [0008] * <br> * paragraph [0027] * <br> * figure 1 * | 8-11 | |

-/--

The present search report has been drawn up for all claims

| Place of search | Date of completion of the search | Examiner |
|---|---|---|
| The Hague | 10 October 2024 | Rocha, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................
& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TLASKAL O ET AL: "Digital detection of instability of higher order bandpass sigma-delta converters", ELECTRONICS LETTERS, THE INSTITUTION OF ENGINEERING AND TECHNOLOGY, GB, vol. 32, no. 21, 10 October 1996 (1996-10-10), pages 1955-1956, XP006005833, ISSN: 0013-5194, DOI: 10.1049/EL:19961326 | 1-4,15 | |
| A | * page 1955, left-hand column, paragraph 4 * <br> * figures 1,2 * <br> ----- | 8-11 | |
| | | | **TECHNICAL FIELDS SEARCHED (IPC)** |

The present search report has been drawn up for all claims

| Place of search | Date of completion of the search | Examiner |
|---|---|---|
| The Hague | 10 October 2024 | Rocha, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.....................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 5398

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2024

| Patent document cited in search report | Publication date | Patent family member(s) | Publication date |
|---|---|---|---|
| US 2002084924 A1 | 04-07-2002 | DE 60018573 T2<br>EP 1202461 A1<br>US 2002084924 A1 | 19-01-2006<br>02-05-2002<br>04-07-2002 |
| US 2015194975 A1 | 09-07-2015 | DE 102014016096 A1<br>GB 2522089 A<br>GB 2538126 A<br>US 2015194975 A1 | 09-07-2015<br>15-07-2015<br>09-11-2016<br>09-07-2015 |
| DE 102007013255 A1 | 25-09-2008 | NONE | |

EPO FORM P0459

For more details about this annex : see Official Journal of the European Patent Office, No. 12/82